# EUROPEAN PATENT APPLICATION

(11) **EP 4 415 030 A1**
(43) Date of publication of application: **14.08.2024**
(21) Application number: 23156263.8
(22) Date of filing: 13.02.2023
(51) Int. Cl.: H01L 21/48, H01L 23/367, H01L 23/467

(54) **COOLING ELEMENT**

(71) Applicant: ABB SCHWEIZ AG, 5400 Baden (CH)
(72) Inventor: Seväkivi, Pertti, 01840 Klaukkala (FI); Björkman, Niko, 05810 Hyvinkää (FI)
(74) Representative: Kolster Oy Ab

(57) **Abstract**

A cooling element (1; 10; 100), comprising a body (2) having a first surface (21) adapted to receive a heat source and a second surface (22) provided with protrusions (3; 30) for forwarding a heat load received from the heat source via the first surface (21), and a gap (4; 40) arranged between the protrusions (3; 30). The protrusion (3; 30) at least partially narrows in the direction towards the body (2), wherein the gap (4; 40) at least partially narrows in the direction away from the body (2).

## Description

### TECHNICAL FIELD

The present invention relates to a cooling element and more precisely to a cooling element for cooling an electric component.

### BACKGROUND

Power electronic switch components or power electronic switch modules require cooling when operated. The cooling is typically produced by attaching the components or modules to a heat sink or a cooling element. The losses from the heat source are led to a surface of a cooling element. The heat source, such as a power electronic module, is attached firmly to the surface of the cooling element. The cooling element transfers the heat away from the heat source and further to external cooling fluid, such as air or liquid.

Previously there is known a cooling element with a first surface for receiving an electric component and a second surface provided with fins for forwarding a heat load received from the electric component via the first surface to the surroundings via the fins. The fins are plates having equal thickness. The external cooling fluid, such as an airflow is provided with a fan blowing cool air between the fins.

A drawback with such a cooling element is the cool airflow tends to escape before optimal cooling capacity is reached.

### BRIEF DESCRIPTION

An object of the present invention is to solve the above-mentioned drawback and to provide a cooling element with improved cooling efficiency.

This and other objects are achieved with a cooling element according to independent claim 1.

A cooling element having a special design was studied and discovered to have improved cooling effect of the cooling fluid.

### BRIEF DESCRIPTION OF THE DRAWINGS

In the following the invention will be described in greater detail by means of preferred embodiments with reference to the attached drawings, in which
Figure 1 illustrates a cooling element according to an embodiment;
Figure 2 illustrates a front view of the cooling element of Figure 1;
Figure 3 illustrates a front view of a cooling element according to another embodiment;
Figure 4 illustrates a front view of a cooling element according to another embodiment;
Figure 5 illustrates a side view of a cooling element according to another embodiment.

### DETAILED DESCRIPTION

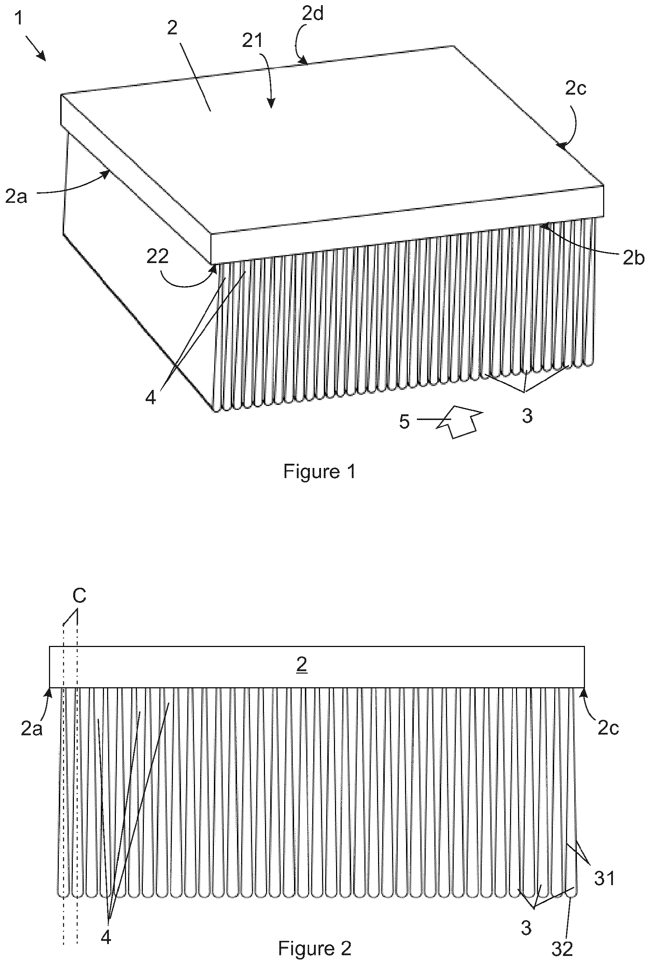

The present invention pertains to a cooling element. Figure 1 illustrates an embodiment of a cooling element 1. Figure 2 illustrates a front view of the cooling element of Figure 1. The cooling element 1 comprises a body 2 having a first surface 21 adapted to receive an electric component, such as a power-semiconductor module, which may be attached to the first surface 21 with screws, for instance. One alternative is that the cooling element 1 is a part of a motor drive, such as a frequency controller, controlling supply of electricity to an electric motor. In that case the electric component may be an IGBT (Insulated Gate Bipolar Transistor) module, for instance.

The body 2 has a second surface 22 which is provided with protrusions 3 for forwarding a heat load received from the electric component to surroundings via the first surface 21. The second surface 22 can be rectangle shaped having four edges, wherein the first edge 2a and the third edge 2c are substantially parallel to each other and the second edge 2b and the fourth edge 2d are parallel to each other and perpendicular to the first edge 2a and the third edge, 2c. However, other shapes can be utilized.

The protrusion 3 have a height which is a dimension from the second surface 22 to the distal end 32 of the protrusion 3, and a length which is a dimension of the protrusion 3 between the second edge 2b and the fourth edge 2d, and a width which is a dimension of the protrusion 3 between the first edge 2a and the third edge 2c.

In the illustrated example the protrusions 3 are fins which are implemented as elongated plates-like elements protruding away (downwards in Figures) from the second surface 22 of the body 2. However, the height of the protrusions 3 can vary. One row from the second edge 2b to the fourth edge 2d of the second surface 22 can comprise one or more protrusions 3. For example, instead of one fin as shown in Figure 1, there can be two or more shorter fins.

A gap 4 is arranged between the protrusions 3 for a cooling fluid to pass between the protrusions to dissipate heat into the cooling fluid. In Figure 1, the cooling fluid is illustrated as an airflow 5 which is arranged to flow in the direction from the second edge 2b to the fourth edge 2d. The airflow 5 can be generated by a fan, for example. The cooling fluid can alternatively be liquid.

The protrusions 3 at least partially narrows or contracts in the direction towards the body 2. Similarly, the gap 4 at least partially narrows or contracts in the direction away from the second surface 22 of the body 2. The gap 4 can narrow along the entire height of the protrusions 3 in the direction away from the body 2 as shown in Figures 1 and 2.

In another embodiment, the protrusion 3 can start widening from the body 2 and at a predetermined height stops widening and have a constant width towards the distal end 32. In yet another embodiment, the protrusion 3 can start as having a constant width from the body 2 and after a predetermined height begins to widen towards the distal end 32.

Centrelines C of the protrusions can be parallel to each other and perpendicular to the second surface 22 of the body 2.

In the embodiment of Figures 1 and 2, a longitudinal cross-section of each protrusion 3 is shaped as a teardrop having two equal sides 31 and a curved distal end 32 connecting said sides 31 so the width of the gap 4 is at its narrowest when the side 31 joins the curved distal end 32. Each protrusion 3 is separate and does not contact neighbouring protrusions 3.

Having the gaps 4 narrowing towards the distal ends 32 of the protrusions 3 increases the velocity of the airflow 5 when flowing away from the body 2 (Bernoulli's principle), with the highest velocity being at its most constricted part. This in turn facilitates the heat dissipation from the protrusions 3 and further enhances the cooling effect.

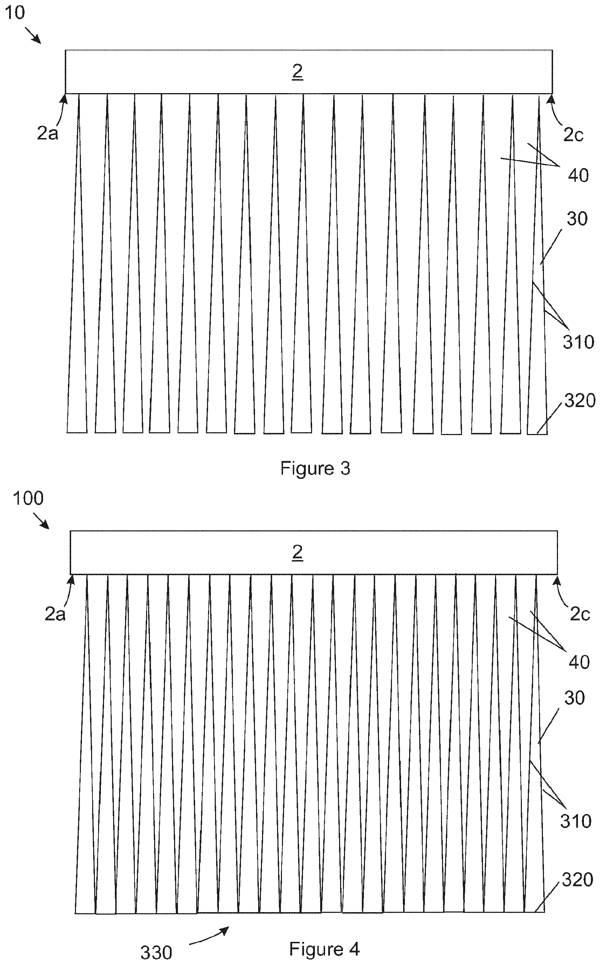

Figure 3 illustrates a front view of a cooling element 10 according to another embodiment. The embodiment of Figure 3 is very similar to the one explained in connection with Figures 1 and 2. Therefore, the embodiment of Figure 3 is in the following mainly explained by pointing out differences.

In the embodiment shown in Figure 3, the longitudinal cross-section of each protrusion 30 is shaped as isosceles triangle having two equal sides 310 and a flat base at the distal end 320. However, in some embodiments, the longitudinal cross-section of each protrusion 30 can alternatively be shaped as scalene triangle having three unequal sides.

Figure 4 illustrates a front view of a cooling element 100 according to another embodiment. The embodiment of Figure 4 is very similar to the one explained in connection with Figure 3. Therefore, the embodiment of Figure 4 is in the following mainly explained by pointing out differences.

In the embodiment shown in Figure 4, distal ends 320 of the protrusions 30 are at least partially connected to each other. This can be done by laser welding, casting, extrusion, or other known manufacture process.

The distal ends 320 can form one single uniform surface 330, or two or more uniform surfaces. The uniform surface 330 can be substantially even, as illustrated in Figure 4, or uneven, if the protrusions have uneven distal ends, as illustrated in Figures 1 and 2 for example.

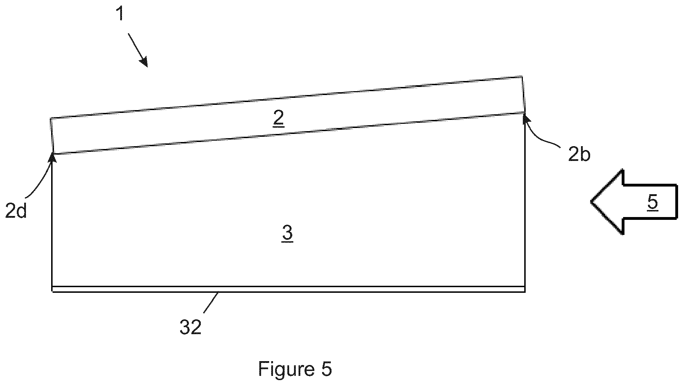

Figure 5 illustrates a side view of the cooling element 1 according to an embodiment. In this embodiment, the protrusions 3 are fins, wherein the gaps 4 having the tallest height are provided at the second edge 2b, and the gaps 4 having the lowest height are provided at the fourth edge 2d. The height of the fins at least partially decreases in the direction from the second edge 2b to the fourth edge 2d. The tallest gaps 4 are arranged to receive cool or ambient airflow 5 which passes between the fins which dissipate heat into the airflow 5. In Figure 5, a longitudinal side of the fin is shaped as right trapezoid having two right angles at the corners of the distal end 32. However, other shapes can be utilized.

With this design, it was observed that it further facilitates the airflow 5 to move toward the second surface 22 and the fourth edge 2d. More heat dissipates from the protrusions 3 and thus provides better cooling capacity to the body 2 and the electric component attached to the body 2.

The production of the described cooling element can be accomplished by preparing a body and metal protrusions of suitable size, and by providing a solder, for instance laser welding, or adhesive, for instance thermally conductive epoxy, at the locations where the protrusions and the body should be connected to each other.

It is to be understood that the above description and the accompanying figures are only intended to illustrate the present invention. It will be obvious to a person skilled in the art that the invention can be varied and modified without departing from the scope of the invention.

## Claims

1. A cooling element (1; 10; 100), comprising
a body (2) having a first surface (21) adapted to receive a heat source and a second surface (22) provided with protrusions (3; 30) for forwarding a heat load received from the heat source via the first surface (21),
a gap (4; 40) arranged between the protrusions (3; 30), **charac-terized** in that the protrusion (3; 30) at least partially narrows in the direction towards the body (2), wherein the gap (4; 40) at least partially narrows in the direction away from the body (2).

2. The cooling element as claimed in claim 1, wherein the protrusion (30) narrows along the entire height of the protrusion (30) in the direction towards the body (2).

3. The cooling element as claimed in claim 1 or 2, wherein a longitudinal cross-section of each of the protrusions (30) is shaped as isosceles triangle.

4. The cooling element as claimed in claim 1 or 2, wherein a longitudinal cross-section of each of the protrusions (30) is shaped as scalene triangle.

5. The cooling element as claimed in claim 1, wherein a longitudinal cross-section of each of the protrusions (3) is shaped as a teardrop having equilateral sides (31) and a curved distal end (32) connecting said sides.

6. The cooling element as claimed in any one of claims 1-5, wherein distal ends (320) of the protrusions (30) are connected to each other.

7. The cooling element as claimed in any one of claims 1-6, wherein centrelines (C) of the protrusions (3; 30) are parallel to each other and perpendicular to the second surface (22).

8. The cooling element as claimed in any one of the claims 1-7, wherein the second surface has four edges (2a, 2b, 2c, 2d), wherein the first edge (2a) and the third edge (2c) are parallel to each other, and the second edge (2b) and the fourth edge (2d) are parallel to each other and perpendicular to the first and third edges (2a, 2c).

9. The cooling element as claimed in claim 8, wherein an airflow (5) is arranged to flow in the direction from the second edge (2b) to the fourth edge (2d).

10. The cooling element as claimed in claim 8 or 9, wherein the height of the protrusion (3; 30) at least partially decreases in the direction from the second edge (2b) to the fourth edge (2d).

11. The cooling element as claimed in any one of claims 1-10, wherein the protrusions (3; 30) are fins.

12. The cooling element as claimed in claim 11, wherein a longitudinal side of the fin is shaped as right trapezoid.

13. The cooling element as claimed in any one of claims 1-12, wherein the at least two protrusions (3; 30) are connected to the body (2) by laser welding.
